# EUROPÄISCHE PATENTSCHRIFT

(11) **EP 4 361 651 B1**
(45) Veröffentlichungstag und Bekanntmachung des Hinweises auf die Patenterteilung: **19.02.2025**
(21) Anmeldenummer: 22204406.7
(22) Anmeldetag: 28.10.2022
(51) Int. Cl.: G01R 31/327, H01H 47/00

(54) **BEDIENVORRICHTUNG MIT FUNKTIONSÜBERWACHUNG DER SCHALTZUSTANDSDETEKTION DES WENIGSTENS EINEN ZUGEHÖRIGEN, BEDIENBAREN SCHALTELEMENTS, ZUGEHÖRIGE VERWENDUNG UND VERFAHREN**
OPERATING DEVICE WITH FUNCTIONAL MONITORING OF THE DETECTION OF THE SWITCHING STATE OF AT LEAST ONE ASSOCIATED OPERABLE SWITCHING ELEMENT, ASSOCIATED USE AND METHOD
DISPOSITIF DE COMMANDE DOTÉ D'UNE SURVEILLANCE FONCTIONNELLE DE LA DÉTECTION DE L'ÉTAT DE COMMUTATION D'AU MOINS UN ÉLÉMENT DE COMMUTATION ACTIONNABLE ASSOCIÉ, UTILISATION ET PROCÉDÉ ASSOCIÉS

(43) Veröffentlichungstag der Anmeldung: 01.05.2024
(73) Patentinhaber: Preh GmbH, 97616 Bad Neustadt a.d. Saale (DE)
(72) Erfinder: Beck, Harald, 97616 Bad Neustadt a.d. Saale (DE); Jeger, Johannes, 97720 Nuedlingen (DE)
(74) Vertreter: Lohmanns, Bernard

(56) Entgegenhaltungen:
- EP-A2- 1 462 768
- DE-A1- 102017 127 047
- US-A1- 2020 070 662
- US-A1- 2022 203 864

## Beschreibung

Die Erfindung bezieht sich auf eine Bedienvorrichtung, die ein durch einen Bediener bedienbares Schaltelement, wie einen Schalter oder Taster, und einen ersten Mikrocontroller zur Ermittlung des jeweiligen Schaltzustands des Schaltelements aufweist. Diese Mikrocontroller weisen typischerweise einen analog-nach-digital wandelnden Eingang auf, um anhand des an dem Eingang anliegenden Potenzials auf den Schaltzustand des Schaltelements zu schließen. In der ISO 26262 ist je nachdem, wie sicherheitsrelevant, die durch die Bedienvorrichtung zusteuernde Fahrzeugfunktion ausfällt, der technische Aufwand festgelegt, mit dem die Funktionssicherheit der Bedienvorrichtung ("funktionelle Sicherheit") gewährleistet werden kann. Dies betrifft beispielswiese den zu verwendeten Mikrocontroller. Dieser Mikrocontroller ist vergleichsweise teuer und aufwändig in der Konstruktion, insbesondere wenn er mehrere Eingänge, beispielsweise zur Ermittlung der Schaltzustände mehrerer Schaltelemente aufweist, und ist gegebenenfalls bei krisenbedingtem Mangel schwierig zu beschaffen. Das Festsitzen im Erfassungsbereich ist ein bekannter Fehlermodus von Mikrocontrollern in einem Kraftfahrzeug. Andere Fehler betreffen die Probleme, dass Werte außerhalb des Erfassungsbereichs, niedrige Werte außerhalb des Erfassungsbereichs und ein Versatz zwischen dem tatsächlichen Wert (Nennwert) und dem gemessenen Wert vorliegt. Ein Mikrokontroller, der im Erfassungsbereich festsitzt, ist derart ausgefallen, dass er ein konstantes Signal erzeugt, das innerhalb des normalen Erfassungsbereichs liegt, dies ist besonders problematisch und schwierig zu detektieren. Eine herkömmliche Plausibilitätsdiagnose, sieht vor die gemessenen Werte eines ersten Mikrocontrollers aufgrund eines ersten Signals mit den gemessenen Werten eines zweiten Mikrocontrollers aufgrund eines zweiten Signals, wobei das erste und zweite Signal korrelierte Signale sind, zu vergleichen, um festzustellen, ob einer der ersten und zweiten Mikrokontroller im Erfassungsbereich festsitzt, indem die absolute Differenz zwischen den Signalen mit einer Fehlergrenze verglichen wird. Wenn die absolute Differenz zu groß ist, wird mindestens eines der gemessenen Werte so aufgefasst, dass der zugehörige Mikrocontroller im Erfassungsbereich festsitzt und fehlerhaft ist. In der Praxis wird die Fehlergrenze für diesen Typ von Plausibilitätsdiagnose ziemlich hoch eingestellt, um fälschliche Anzeigen eines Fehlers durch die Diagnose zu minimieren. Folglich ist dieser Typ von Plausibilitätsdiagnose auf das Diagnostizieren von Mikrocontrollern beschränkt, die einen erheblichen Versatzbetrag aufweisen, oder diejenigen, die im Erfassungsbereich bei einem Wert weit entfernt vom Nennwert festsitzen, so dass dieser Typ von Plausibilitätsdiagnose einen Detektionsbereich aufweist, der ähnlich wie eine Diagnose außerhalb des Erfassungsbereichs ist und in der Empfindlichkeit auf diejenige dieser Diagnose begrenzt ist.

DE 10 2017 127047 A1 beschreibt ein R2R-Widerstandsnetzwerk zur Überwachung des Zustands einer Vielzahl von Schaltern.

Vor diesem Hintergrund bestand Bedarf nach einer Bedienvorrichtung, bei der eine Funktionsüberwachung zuverlässig gewährkleistet ist, insbesondere das Feststecken des Mikrocontrollers im Erfassungsbereich zuverlässig detektiert werden kann, sowie eine ISO 26262 konforme Funktionsüberwachung, vergleichsweise einfach und damit kostengünstig realisiert werden kann. Diese Aufgabe wird durch eine Bedienvorrichtung des Anspruch 1 gelöst. Eine gleichermaßen vorteilhafte Verwendung sowie ein Verfahren zur Funktionsüberwachung ist jeweils Gegenstand der nebengeordneten Ansprüche. Vorteilhafte Ausgestaltungen sind Gegenstand der jeweils abhängigen Ansprüche. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, charakterisiert und spezifiziert die Erfindung zusätzlich.

Die Erfindung betrifft eine Bedienvorrichtung, die einen ersten Mikrocontroller mit wenigstens einem ersten Messeingang, der zur Wandlung eines jeweils am ersten Messeingang anliegenden Messpotentials in ein jeweilig zugehöriges, von dem jeweiligen Messpotenzial abhängiges Detektionsergebnis ausgebildet ist. Erfindungsgemäß ist ferner eine Spannungsquelle mit einer durch zwei Versorgungspotenziale vorgegebenen Versorgungsspannung vorgesehen.

Die erfindungsgemäße Vorrichtung weist ferner ein mit der Versorgungsspannung beaufschlagtes Widerstandnetzwerk auf, wobei der erste Messeingang des ersten Mikrocontrollers mit einem ersten Abgriff am Widerstandsnetzwerk elektrisch leitend verbunden ist.

Erfindungsgemäß ist mindestens ein in dem Widerstandnetzwerk integriertes Schaltelement, dessen Schaltzustand aus mindestens zwei Schaltzuständen durch Bedienen, Berühren und/oder Betätigen, eines Bedieners von einem Schaltzustand in den jeweils anderen Schaltzustand gewechselt wird. Beispielsweise handelt es sich bei dem Schaltelement, um einen elektromechanischen Schalter oder Taster, oder einen kapazitiv- oder resistivsensorisches Schaltelement.

Erfindungsgemäß ist das Widerstandsnetzwerk so ausgebildet ist, dass dem jeweiligen Schaltzustand ein anderes, an dem ersten Messeingang anliegendes Schaltpotenzial zugeordnet ist, und wenigstens ein Schaltpotenzial sich von den Versorgungspotenzialen unterscheidet, bevorzugt sich alle Schaltpotenziale von den Versorgungspotenzialen unterscheiden,

Erfindungsgemäß ist ferner ein dem ersten Mikrocontroller übergeordneter, zweiter Mikrocontroller vorgesehen, der ausgebildet ist, das jeweilige Detektionsergebnis des ersten Mikrocontrollers zu empfangen und an eine übergeordnete Steuereinheit auszugeben. Übergeordnet meint, dass der zweite Mikrocontroller auf dem Weg der Datenübermittlung des Detektionsergebnisses vom ersten Mikrocontroller zur Steuereinheit nicht nur zwischengeschaltet ist, sondern über die Weitergabe an die Steuereinheit in Abhängigkeit einer von ihm getriggerten Funktionsüberprüfung entscheidet.

Dazu ist erfindungsgemäß ein vom zweiten Mikrocontroller steuerbares, in das Widerstandsnetzwerk integriertes, aktives Bauelement vorgesehen, um das am ersten Messeingang anliegende Messpotenzial durch Beeinflussung des Widerstandsnetzwerks auf ein sich von allen Schaltpotenzialen unterscheidendes Störpotenzial zu legen. Beispielsweise ist das aktive Bauelement ein elektromechanischer Schalter oder ein halbleiterbasiertes Schaltelement, wie ein Transistor. Beispielsweise wird durch das aktive Bauelement ein zusätzlicher Zweig im Widerstandsnetzwerk geschaltet. Das Störpotenzial liegt bevorzugt zwischen den Versorgungspotenzialen.

Erfindungsgemäß ist der zweite Mikrokontroller ausgebildet, im Falle einer Nicht-Detektion des Störpotenzials durch den ersten Mikrocontroller während der Ansteuerung des aktiven Bauelements eine nachfolgende Ausgabe des Detektionsergebnis an die übergeordnete Steuereinheit zumindest vorübergehende zu unterdrücken. Durch die erfindungsgemäße Auslegung lässt sich eine Fehlfunktion des ersten Mikrocontrollers, aber insbesondere dessen Festsitzen im Erfassungsbereich zuverlässig detektieren, insbesondere kann eine mikrocontroller-basierte Detektion leicht durch eine einfache Erweiterung mit einer übergeordneten Überprüfung durch einen weiteren Mikrocontroller in eine ISO 26262 konforme Auslegung überführt werden.

Bevorzugt ist das Widerstandsnetzwerk als Wheatstone-Brücke ausgebildet, Beispielsweise umfasst das Widerstandnetzwerk zwei zwischen den Versorgungspotenzialen parallel verschaltete Stromzweige aus jeweils mehreren in Reihe geschalteten Widerständen, von denen wenigstens ein Widerstand durch das aktive Bauelement veränderbar, bevorzugt durch selektives Parallelschalten weiterer Widerstände oder selektives Überbrücken veränderbar ist.

Bevorzugt ist das Widerstandsnetzwerk als R2R-Widerstandsnetzwerk ausgebildet. Dadurch ist es möglich, mit einem einzigen Eingang des Mikrocontrollers mehr als zwei Schaltzustände pro Schaltelement bzw. mehr als ein Schaltelement auf seinen Schaltzustand hin auszuwerten.

Um die Störempfindlichkeit gegenüber elektromagnetischer Einstreuung zu erhöhen, weist der erste Mikrocontroller einen zweiten Messeingang auf, der mit einem sich vom ersten Abgriff unterscheidenden, zweiten Abgriff im Widerstandnetzwerk elektrisch leitend verbunden ist und ausgebildet ist, das Detektionsergebnis aus einem Potenzialunterschied zwischen dem am ersten Messeingang und zweiten Messeingang jeweils anliegenden Messpotenzial zu bestimmen. Beispielsweise erfolgt der erste und zweite Abgriff an jeweils einem anderen Zweig und dabei jeweils zwischen zwei Widerständen des als Wheatstone-Brücke ausgebildeten Widerstandsnetzwerks.

Bevorzugt sind zwei Schaltelemente vorgesehen, deren Schaltzustände aus mindestens zwei Schaltzuständen durch Betätigen eines Bedieners gewechselt werden, wobei die Schaltelemente in unterschiedlichen Zweigen des Widerstandsnetzwerks integriert sind.

Bevorzugt wird das aktive Bauelement periodisch durch den zweiten Mikrocontroller angesteuert. Beispielsweise verifiziert der zweite Mikrocontroller anhand der wiederholten Detektion des Störpotenzials durch den ersten Mikrocontrollers dessen Zuverlässigkeit.

Bevorzugt ist der zweite Mikrocontroller ausgebildet, einen Störfall an die übergeordnete Steuereinheit zu melden.

Die Erfindung betrifft ferner die Verwendung der Bedienvorrichtung in einer der zuvor beschriebenen Ausführungsformen in einem Kraftfahrzeug zur Funktionsüberwachung einer sicherheitsrelevanten Schaltzustandsdetektion,

Die Erfindung betrifft ferner ein Verfahren zur Funktionsüberwachung einer Schaltzustandsdetektion mit den folgenden Schritten. In einem Bereitstellungsschritt wird eine Bedienvorrichtung in einer der zuvor beschriebenen Ausführungsformen bereitgestellt. In einem Ansteuerschritt des erfindungsgemäßen Verfahrens erfolgt ein Ansteuern des aktiven Bauelements derart, dass das am ersten Messeingang anliegende Messpotenzial durch Beeinflussung des Widerstandsnetzwerks auf einem sich von allen Schaltpotenzialen unterscheidenden Störpotenzial liegt. In einem gleichzeitigen oder nachfolgenden Schritt werden erfindungsgemäß die ansonsten vorgesehene Ausgabe und Übermittlung des Detektionsergebnisses von dem zweiten Mikrocontroller an eine übergeordnete Steuereinheit für den Fall ausgesetzt, dass vorher das Störpotenzial während der durch den zweiten Mikrokontroller bewirkten Ansteuerung des aktiven Bauelements von dem ersten Mikrokontroller nicht detektiert wurde. Dadurch lässt sich eine Fehlfunktion des Mikrocontrollers, aber insbesondere dessen Festsitzen im Erfassungsbereich zuverlässig detektieren.

Andere vorteilhafte Ziele, Nutzen und Umsetzungen dieser Erfindung gehen aus der detaillierten Beschreibung eines konkreten Ausführungsbeispiels in Verbindung mit der beigelegten Zeichnung deutlicher hervor, in welcher:

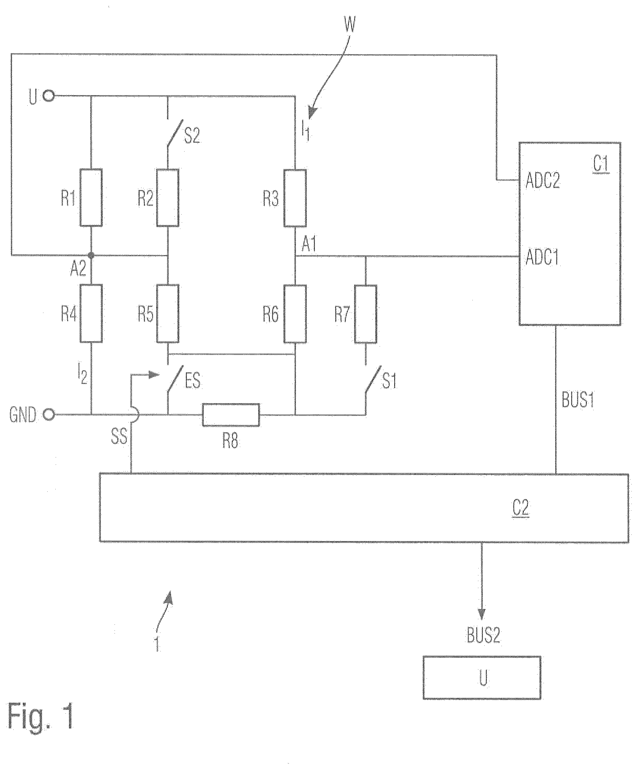

- Fig. 1: ein Ausführungsbeispiel eines elektronischen Schaltplans der Vorrichtung gemäß dieser Erfindung darstellt.

Die Erfindung betrifft eine Bedienvorrichtung 1, die einen ersten Mikrocontroller C1 mit einem ersten Messeingang ADC1 und einen zweiten Messeingang ADC2 aufweist, die jeweils zur Wandlung eines jeweils am ersten Messeingang ADC1 bzw. zweiten Messeingang ADC2 anliegenden Messpotentials in ein jeweilig zugehöriges, von dem jeweiligen Messpotenzial abhängiges Detektionsergebnis ausgebildet sind. Es ist ferner eine Spannungsquelle mit einer durch zwei Versorgungspotenziale U und GND vorgegebenen Versorgungsspannung vorgesehen. Mit der aus den Versorgungspotenzialen U und GND gebildeten Versorgungsspannung wird ein Widerstandnetzwerk W beaufschlagt.

Der erste Messeingang ADC1 des ersten Mikrocontrollers C1 mit einem ersten Abgriff A1 des Widerstandsnetzwerks W elektrisch leitend verbunden, während ein zweiter Abgriff A1 des Widerstandnetzwerks W elektrisch leitend mit dem zweiten Messeingang ADC2 des ersten Mikrokontrollers C1 verbunden ist. Das Widerstandsnetzwerk W ist als Wheatstone-Brücke ausgebildet, so umfasst das Widerstandnetzwerk W zwei zwischen den Versorgungspotenzialen U, GND parallel verschaltete Stromzweige I1, 12 mit jeweils mehreren in Reihe geschalteten Widerständen pro Stromzweig I1, I2, nämlich R1, R4 im Stromzweig 12 und R3, R6 und R8 im Stromzweig I1. Hier erfolgt der erste Abgriff A1 im ersten Zweig I1 und der zweite Abgriff A2 im zweiten Zweig I2 und dabei jeweils zwischen zwei Widerständen des als Wheatstone-Brücke ausgebildeten Widerstandsnetzwerks W.

Ferner sind zwei in dem Widerstandnetzwerk W integrierte Schaltelement S1 und S2 vorgesehen, deren Schaltzustand aus mindestens zwei Schaltzuständen durch Bedienen, Berühren und/oder Betätigen, eines Bedieners von einem Schaltzustand in den jeweils anderen Schaltzustand gewechselt werden kann. Beispielsweise handelt es sich bei dem ersten Schaltelement S1 und zweiten Schaltelement S2, jeweils um einen elektromechanischen Schalter oder Taster. Je nach Schaltzustand des Schaltelements S1 wird dem Widerstand R6 der Widerstand R7 parallelgeschaltet, während je nach Schaltzustand des Schaltelements S2 dem Widerstand R1 der Widerstand R2 parallelgeschaltet wird, so dass am ersten Messeingang ADC1 bzw. zweiten Messeingang ADC2 jeweils das vom Schaltzustand der Schaltelemente S1, S2 abhängige Schaltpotenzial anliegt.

Das Widerstandsnetzwerk W ist so ausgebildet, dass dem jeweiligen Schaltzustand des ersten und zweiten Schaltelements S1 S2 ein anderes Schaltpotenzial, zumindest pro Messeingang zugeordnet ist, und sich alle Schaltpotenziale von den Versorgungspotenzialen U und GND unterscheiden.

Der erste Mikrocontroller C1 ist ausgebildet, die an dem ersten Messeingang ADC1 bzw. zweiten Messeingang ADC2 anliegenden Schaltpotenziale als Bedieneingabe des ersten Schaltelements S1 beziehungsweise des zweiten Schaltelements S2 durch differentielle Auswertung zu detektieren und über einen ersten Datenbus BUS1 an einen übergeordneten Mikrocontroller C2 zu übermitteln.

Der dem ersten Mikrocontroller C1 übergeordnete, zweite Mikrocontroller C2 ist vorgesehen und ausgebildet, das jeweilige Detektionsergebnis des ersten Mikrocontrollers C1 zu empfangen und an eine übergeordnete Steuereinheit U über einen zweiten Datenbus BUS 2 auszugeben. Übergeordnet meint, dass der zweite Mikrocontroller C2 auf dem Weg der Datenübermittlung des Detektionsergebnisses vom ersten Mikrocontroller C1 zur Steuereinheit U nicht nur zwischengeschaltet ist, sondern über die Weitergabe an die Steuereinheit U in Abhängigkeit einer von ihm getriggerten Funktionsüberprüfung entscheidet.

Dazu ist erfindungsgemäß ein vom zweiten Mikrocontroller C2 über eine Ansteuerleitung SS steuerbares, in das Widerstandsnetzwerk W integriertes, aktives Bauelement ES vorgesehen, um das am ersten Messeingang ADC1 und am zweiten Messeingang ADC2 anliegende Messpotenzial durch Beeinflussung des Widerstandsnetzwerks W jeweils auf ein sich von allen Schaltpotenzialen unterscheidendes Störpotenzial zu legen. Hier ist das aktive Bauelement ES ein halbleiterbasiertes Schaltelement, wie ein Transistor. Das Störpotenzial kann dabei für den ersten Messeingang ADC1 und den zweiten Messeingang ADC2 unterschiedlich sein.

Der zweite Mikrokontroller C2 ist ausgebildet, im Falle einer Nicht-Reaktion des ersten Mikrocontrollers C1 auf das Anliegend des Störpotenzials während der Ansteuerung des aktiven Bauelements ES, eine nachfolgende Ausgabe des Detektionsergebnis an die übergeordnete Steuereinheit U zumindest vorübergehende zu unterdrücken. Durch die erfindungsgemäße Auslegung lässt sich eine Fehlfunktion des ersten Mikrocontrollers C1, aber insbesondere dessen Festsitzen im Erfassungsbereich zuverlässig detektieren.

## Patentansprüche

1. Bedienvorrichtung (1), aufweisend:
einen ersten Mikrocontroller (C1) mit wenigstens einem ersten Messeingang (ADC1), der zur Wandlung eines jeweils am ersten Messeingang (ADC1) anliegenden Messpotentials in ein jeweilig zugehöriges, von dem jeweiligen Messpotenzial abhängiges Detektionsergebnis ausgebildet ist;
eine Spannungsquelle mit einer durch zwei Versorgungspotenziale (U, GND) vorgegebenen Versorgungsspannung;
ein mit der Versorgungsspannung beaufschlagtes Widerstandnetzwerk (W), wobei der erste Messeingang (ADC1) mit einem ersten Abgriff (A1) am Widerstandsnetzwerk (W) elektrisch leitend verbunden ist;
mindestens ein in dem Widerstandnetzwerk (W) integriertes Schaltelement (S1, S2), dessen Schaltzustand aus mindestens zwei Schaltzuständen durch Bedienen eines Bedieners gewechselt wird; wobei das Widerstandsnetzwerk (W) so ausgebildet ist, dass dem jeweiligen Schaltzustand ein anderes, am ersten Messeingang (ADC1) anliegendes Schaltpotenzial zugeordnet ist, und wenigstens ein Schaltpotenzial sich von den Versorgungspotenzialen (U, GND) unterscheidet;
ein dem ersten Mikrocontroller (C1) übergeordneter, zweiter Mikrocontroller (C2), der ausgebildet ist, das jeweilige Detektionsergebnis des ersten Mikrocontrollers (C1) zu empfangen und an eine übergeordnete Steuereinheit (U) auszugeben;
ein vom zweiten Mikrocontroller (C2) steuerbares, in das Widerstandsnetzwerk (W) integriertes, aktives Bauelement (ES), um das am ersten Messeingang (ADC1) anliegende Messpotenzial durch Beeinflussung des Widerstandsnetzwerks (W) auf ein sich von allen Schaltpotenzialen unterscheidendes Störpotenzial zu legen;
wobei der zweite Mikrokontroller (C2) ausgebildet ist, im Falle, dass das Detektionsergebnis des ersten Mikrocontrollers (C1) während der Ansteuerung des aktiven Bauelements (ES) nicht dem des Störpotenzials entspricht, eine nachfolgende Ausgabe des Detektionsergebnis an die übergeordnete Steuereinheit (U) zumindest vorübergehend zu unterdrücken.

2. Bedienvorrichtung (1) nach Anspruch 1, wobei das Widerstandsnetzwerk (W) als Wheatstone-Brücke ausgebildet ist.

3. Bedienvorrichtung (1) nach einem der vorhergehenden Ansprüche, wobei das Widerstandsnetzwerk (W) als R2R-Widerstandsnetzwerk ausgebildet ist.

4. Bedienvorrichtung (1) nach einem der vorhergehenden Ansprüche, wobei der erste Mikrocontroller (C1) einen zweiten Messeingang (ADC2) aufweist, der mit einem sich vom ersten Abgriff (A1) unterscheidenden, zweiten Abgriff (A2) im Widerstandnetzwerk (W) elektrisch leitend verbunden ist und ausgebildet ist, das Detektionsergebnis aus einem Potenzialunterschied zwischen dem am ersten Messeingang (ADC1) und zweiten Messeingang (ADC2) jeweils anliegenden Messpotenzial zu bestimmen.

5. Bedienvorrichtung (1) nach einem der vorhergehenden Ansprüche, aufweisend zwei Schaltelemente (S1, S2), deren Schaltzustände aus mindestens zwei Schaltzuständen durch Betätigen eines Bedieners gewechselt werden und die Schaltelemente (S1, S2) in unterschiedlichen Zweigen des Widerstandsnetzwerks (W) integriert sind.

6. Bedienvorrichtung (1) nach einem der vorhergehenden Ansprüche, wobei das aktive Bauelement (ES) ein halbleiterbasiertes Schaltelement ist.

7. Bedienvorrichtung (1) nach einem der vorhergehenden Ansprüche, wobei das aktive Bauelement (ES) periodisch durch den zweiten Mikrocontroller (C2) angesteuert wird.

8. Bedienvorrichtung (1) nach einem der vorhergehenden Ansprüche, wobei der zweite Mikrocontroller (C2) ausgebildet ist, einen Störfall an die übergeordnete Steuereinheit (U) zu melden.

9. Verwendung der Bedienvorrichtung (1) gemäß einem der vorhergehenden Ansprüche in einem Kraftfahrzeug zur Funktionsüberwachung einer sicherheitsrelevanten Schaltzustandsdetektion.

10. Verfahren zur Funktionsüberwachung einer Schaltzustandsdetektion mit den folgenden Schritten:
Bereitstellen einer Bedienvorrichtung (1) gemäß einem der vorhergehenden Ansprüche 1 bis 8;
Ansteuern des aktiven Bauelements (ES) derart, dass das am ersten Messeingang (ADC1) anliegende Messpotenzial durch Beeinflussung des Widerstandsnetzwerks (W) auf ein sich von allen Schaltpotenzialen unterscheidendes Störpotenzial liegt;
Unterdrücken einer Ausgabe des Detektionsergebnisses von dem zweiten Mikrocontroller (C2) an die übergeordnete Steuereinheit (U) für den Fall, dass das Detektionsergebnis des ersten Mikrocontrollers (C1) während der durch den zweiten Mikrokontroller (C2) bewirkten Ansteuerung des aktiven Bauelements (ES) von dem ersten Mikrokontroller (C1) nicht dem des Störpotenzials entspricht.

## Claims

1. Operating device (1), comprising:
a first microcontroller (C1) having at least a first measurement input (ADC1), which is designed for converting a measurement potential present in each case at the first measurement input (ADC1) into a respectively associated detection result dependent on the respective measurement potential;
a voltage source having a supply voltage predefined by two supply potentials (U, GND);
a resistor network (W) to which the supply voltage is applied, wherein the first measurement input (ADC1) is electrically conductively connected to a first tap (A1) at the resistor network (W);
at least one switching element (S1, S2) which is integrated in the resistor network (W) and whose switching state out of at least two switching states is changed by operation on the part of an operator; wherein the resistor network (W) is designed such that the respective switching state is assigned a different switching potential present at the first measurement input (ADC1), and at least one switching potential differs from the supply potentials (U, GND);
a second microcontroller (C2), which is superordinate to the first microcontroller (C1) and is designed to receive the respective detection result of the first microcontroller (C1) and to output it to a superordinate control unit (U);
an active component (ES) integrated in the resistor network (W) and controllable by the second microcontroller (C2), in order that the measurement potential present at the first measurement input (ADC1) is put at an interference potential differing from all the switching potentials as a result of influencing of the resistor network (W);
wherein the second microcontroller (C2) is designed, in the case where the detection result of the first microcontroller (C1) does not correspond to that of the interference potential during the control of the active component (ES), to suppress a subsequent output of the detection result to the superordinate control unit (U) at least temporarily.

2. Operating device (1) according to Claim 1, wherein the resistor network (W) is designed as a Wheatstone bridge.

3. Operating device (1) according to either of the preceding claims, wherein the resistor network (W) is designed as an R2R resistor network.

4. Operating device (1) according to any of the preceding claims, wherein the first microcontroller (C1) comprises a second measurement input (ADC2), which is electrically conductively connected to a second tap (A2) differing from the first tap (A1) in the resistor network (W) and is designed to determine the detection result from a potential difference between the measurement potentials respectively present at the first measurement input (ADC1) and the second measurement input (ADC2).

5. Operating device (1) according to any of the preceding claims, comprising two switching elements (S1, S2) whose switching states out of at least two switching states are changed by actuation on the part of an operator and the switching elements (S1, S2) are integrated in different branches of the resistor network (W).

6. Operating device (1) according to any of the preceding claims, wherein the active component (ES) is a semiconductor-based switching element.

7. Operating device (1) according to any of the preceding claims, wherein the active component (ES) is periodically controlled by the second microcontroller (C2).

8. Operating device (1) according to any of the preceding claims, wherein the second microcontroller (C2) is designed to report an interference situation to the superordinate control unit (U).

9. Use of the operating device (1) according to any of the preceding claims in a motor vehicle for the functional monitoring of a safety-relevant switching state detection.

10. Method for the functional monitoring of a switching state detection comprising the following steps:
providing an operating device (1) according to any of the preceding Claims 1 to 8;
controlling the active component (ES) in such a way that the measurement potential present at the first measurement input (ADC1) is at an interference potential differing from all the switching potentials as a result of influencing of the resistor network (W);
suppressing an output of the detection result from the second microcontroller (C2) to the superordinate control unit (U) for the case where the detection result of the first microcontroller (C1) does not correspond to that of the interference potential during the control of the active component (ES) by the first microcontroller (C1), said control being brought about by the second microcontroller (C2).

## Revendications

1. Dispositif d'utilisation (1), présentant :
un premier microcontrôleur (C1) pourvu d'au moins une première entrée de mesure (ADC1), qui est réalisé pour convertir un potentiel de mesure appliqué respectivement à la première entrée de mesure (ADC1) en un résultat de détection respectivement associé, dépendant du potentiel de mesure respectif ;
une source de tension ayant une tension d'alimentation prédéfinie par deux potentiels d'alimentation (U, GND) ;
un réseau de résistances (W) sollicité par la tension d'alimentation, dans lequel la première entrée de mesure (ADC1) est reliée de manière électriquement conductrice à une première prise (A1) au niveau du réseau de résistances (W) ;
au moins un élément de commutation (S1, S2) intégré dans le réseau de résistances (W) et dont l'état de commutation parmi au moins deux états de commutation est changé par l'utilisation d'un utilisateur ; dans lequel le réseau de résistances (W) est réalisé de telle sorte qu'un autre potentiel de commutation appliqué à la première entrée de mesure (ADC1) est associé à l'état de commutation respectif, et au moins un potentiel de commutation est différent des potentiels d'alimentation (U, GND) ;
un deuxième microcontrôleur (C2) supérieur au premier microcontrôleur (C1) et qui est réalisé pour recevoir le résultat de détection respectif du premier microcontrôleur (C1) et pour le sortir à une unité de commande (U) supérieure ;
un composant actif (ES) pouvant être commandé par le deuxième microcontrôleur (C2) et intégré dans le réseau de résistances (W) pour mettre le potentiel de mesure appliqué à la première entrée de mesure (ADC1) sur un potentiel perturbateur différent de tous les potentiels de commutation en influençant le réseau de résistances (W) ;
dans lequel le deuxième microcontrôleur (C2) est réalisé pour supprimer au moins temporairement une sortie consécutive du résultat de détection à l'unité de commande (U) supérieure au cas où le résultat de détection du premier microcontrôleur (C1) pendant le pilotage du composant actif (ES) ne correspond pas à celui du potentiel perturbateur.

2. Dispositif d'utilisation (1) selon la revendication 1, dans lequel le réseau de résistances (W) est réalisé sous forme de pont de Wheatstone.

3. Dispositif d'utilisation (1) selon l'une quelconque des revendications précédentes, dans lequel le réseau de résistances (W) est réalisé sous la forme d'un réseau de résistances R2R.

4. Dispositif d'utilisation (1) selon l'une quelconque des revendications précédentes, dans lequel le premier microcontrôleur (C1) présente une deuxième entrée de mesure (ADC2) qui est reliée de manière électriquement conductrice à une deuxième prise (A2) dans le réseau de résistances (W), différente de la première prise (A1), et est réalisé pour déterminer le résultat de détection à partir d'une différence de potentiel entre le potentiel de mesure respectivement appliqué à la première entrée de mesure (ADC1) et à la deuxième entrée de mesure (ADC2).

5. Dispositif d'utilisation (1) selon l'une quelconque des revendications précédentes, présentant deux éléments de commutation (S1, S2) dont les états de commutation parmi au moins deux états de commutation sont changés par l'utilisation d'un utilisateur, et les éléments de commutation (S1, S2) sont intégrés dans différentes branches du réseau de résistances (W).

6. Dispositif d'utilisation (1) selon l'une quelconque des revendications précédentes, dans lequel le composant actif (ES) est un élément de commutation à base de semi-conducteur.

7. Dispositif d'utilisation (1) selon l'une quelconque des revendications précédentes, dans lequel le composant actif (ES) est piloté périodiquement par le deuxième microcontrôleur (C2).

8. Dispositif d'utilisation (1) selon l'une quelconque des revendications précédentes, dans lequel le deuxième microcontrôleur (C2) est réalisé pour signaler une panne à l'unité de commande (U) supérieure.

9. Utilisation du dispositif d'utilisation (1) selon l'une quelconque des revendications précédentes dans un véhicule automobile pour la surveillance fonctionnelle d'une détection d'état de commutation importante pour la sécurité.

10. Procédé de surveillance fonctionnelle d'une détection d'état de commutation, comprenant les étapes suivantes consistant à :
fournir un dispositif d'utilisation (1) selon l'une quelconque des revendications 1 à 8 ;
piloter le composant actif (ES) de telle sorte que le potentiel de mesure appliqué à la première entrée de mesure (ADC1) se trouve à un potentiel perturbateur différent de tous les potentiels de commutation en influençant le réseau de résistances (W) ;
supprimer une sortie du résultat de détection du deuxième microcontrôleur (C2) à l'unité de commande (U) supérieure au cas où le résultat de détection du premier microcontrôleur (C1) pendant le pilotage du composant actif (ES) du premier microcontrôleur (C1), provoqué par le deuxième microcontrôleur (C2), ne correspond pas à celui du potentiel perturbateur.
